**Europäisches Patentamt**

**European Patent Office**

**Office européen des brevets**

(11) Publication number:  **0 125 006**
**B1**

## (12) EUROPEAN PATENT SPECIFICATION

(45) Date of publication of patent specification: **11.11.87**

(21) Application number: **84302260.9**

(22) Date of filing: **03.04.84**

(51) Int. Cl.⁴: **G 01 R 13/42, G 01 R 29/12**

(54) Apparatus for measuring the electric potential of an electrostatic field.

(30) Priority: **06.04.83 JP 61110/83**
**08.12.83 JP 232162/83**

(43) Date of publication of application:
**14.11.84 Bulletin 84/46**

(45) Publication of the grant of the patent:
**11.11.87 Bulletin 87/46**

(84) Designated Contracting States:
**CH DE FR GB IT LI NL**

(56) References cited:
**DE-C- 364 199**
**FR-A-2 388 279**
**US-A-2 817 814**

(73) Proprietor: **SANKI ELECTRONIC INDUSTRY**
**1-6, Eda Kita 2-Chome Midori-Ku**
**Yokohama-Shi Kanagawa-Ken (JP)**

(72) Inventor: **Kaneko, Yoshiaki**
**1533, Sugao Miyamae-ku**
**Kawasaki-Shi Kanagawa-Ken (JP)**
Inventor: **Kawamura, Takeyoshi**
**3549-60, Akuwa-Cho Seya-Ku**
**Yokohama-Shi Kanagawa-Ken (JP)**

(74) Representative: **Nettleton, John Victor et al**
**Abel & Imray Northumberland House**
**303-306 High Holborn**
**London, WC1V 7LH (GB)**

Courier Press, Leamington Spa, England.

## Description

The present invention relates to an apparatus for measuring the electric potential of an electrostatic field.

Various measuring instruments have conventionally been developed for measuring the intensity of electrostatic field in terms of quantities of electric charge, such as a series of detectors, e.g., Kolbe charge electrostatic meter, Braun electro potentio meter, Wilson charge quantity meter, etc., (vesorium-type charge quantity meters) and rotary-sector-type electric potential measuring instruments using an electrostatic induction phenomenon. However, there are various disadvantages in such measuring instruments in that the former instruments are insufficiently accurate in terms of quantitative measurements and the latter instruments are complex in structure and cannot also make an accurate measurement in cases where the electrostatic field is anisotropic although the accurate measurement can be made in cases where the electrostatic field is isotropic.

DE—C—364 199 discloses a method of measuring high voltage when testing a high-voltage article using a spark gap. A pair of spheres of adjustable spacing mounted on a stand are wired in parallel with the article under test to the output side of a high tension transformer. A motor drives a mechanism for gradually bringing the spheres closer to each other. When a spark jumps between the spheres the resulting electromagnetic waves are picked up by an aerial coupled to a cohere connected to a relay arranged to interrupt the supply to the motor. The spacing of the two spheres is indicated by a scale and a moving pointer coupled to one of the spheres.

FR—A—2 388 279 discloses apparatus for measuring remotely the intensity of an electric current flowing in a high voltage circuit. The current, which in one example is derived from a probe extending into an electric field, flows through a conductor to a relaxation oscillator constituted by a luminous discharge tube in parallel with a capacitor. Luminous impulses from the tube are conveyed to a remote point by a light conductor and there applied to a transducer circuit.

With the above-described matters in mind, it is an object of the present invention to provide an apparatus for measuring the electric potential of an electrostatic field which has a simple structure and can accurately measure the electric potential at any point of the electrostatic field regardless of whether it is isotropic or anisotropic in the distribution of electric charge.

The present invention provides apparatus for measuring electric potential using a discharge gap, the apparatus comprising:

first and second electrodes opposing each other with a gaseous discharge gap therebetween; and

means for detecting and indicating the occurrence of a discharge across the discharge gap; characterized in that:

the first and second electrodes constitute a sensor unit, the means for detecting the occurrence of a discharge across the discharge gap comprises circuitry which has no physical connection to the sensor unit, and in that the sensor unit is positionable at any desired location within an electrostatic field to cause the electrodes to be charged by electrostatic induction according to the value of the potential of the electrostatic field at the location so that the detection of a discharge between the electrodes by the circuitry is indicative of the electric potential at that location.

The invention also provides a method of measuring electric potential comprising:

using the detection, by circuitry, of a discharge across a gaseous discharge gap between electrodes as an indication of the value of the electric potential between the electrodes, characterized by:

positioning at a desired location within an electrostatic field a sensor unit comprising first and second electrodes opposing each other with the gaseous discharge gap therebetween, thereby causing the electrodes to be charged by electrostatic induction according to the value of the potential of the electrostatic field at that location, and

detecting the occurrence of a discharge across the discharge gap by means of circuitry which has no physical connection to the sensor unit.

Ways of carrying out the invention are described in detail below with reference to drawings which illustrate two specific embodiments.

In the attached drawings in which like reference numerals designate corresponding elements:

Fig. 1 is a block diagram of a first preferred embodiment of an apparatus for measuring the electric potential of an electrostatic field according to the present invention;

Fig. 2 is a block diagram of a second preferred embodiment according to the present invention; and

Figs. 3(A) and 3(B) show other examples of application of the apparatus shown in Figs. 1 and 2 to measurement of the electrical potential of an electrostatic field.

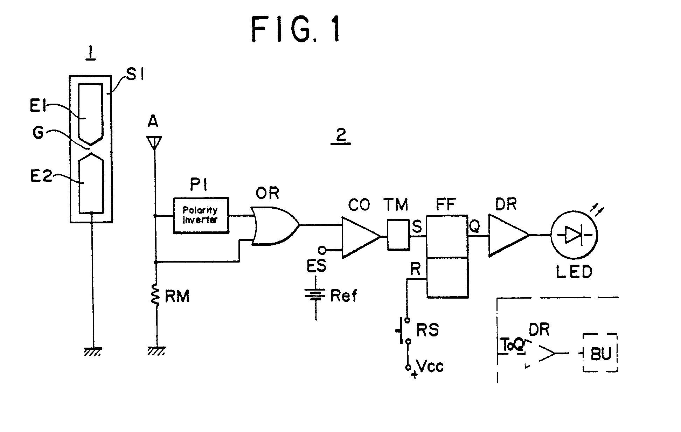

Referring now to the drawings in which, Fig. 1 shows a first preferred embodiment according to the present invention.

In Fig. 1, symbol E1 denotes a first electrode, E2 denotes a second electrode opposing to the first electrode E1 and which is grounded, SI denotes an insulating support, and G denotes a discharge gap between the first and second electrodes E1 and E2. These elements form a sensing section 1 portable to any point of measurement.

It should be noted that, in this embodiment, an appropriate adhesive is used to fix both the electrodes E1 and E2 to the insulating support SI. Alternatively, the first electrode E1 may be adjustably positioned, e.g., engaging a guide groove (not shown) provided within the insulating support SI so as to allow adjustment of the discharge gap G when a lock screw (not shown) in the insulating support SI and in engagement with the first electrode E1 via the guide groove is loosened from the first electrode E1, with the grounded second electrode E2 fixed to the insulating support SI. In this case, the first electrode E1 is fixed to the insulating support SI so that the discharge gap G is fixed. Alternatively, the grounded second electrode E2 may be adjustable with the first electrode E1 fixed to the insulating support SI or both electrodes E1, D2 may be adjustable.

In addition, in Fig. 1 symbol A denotes a small telescoping antenna or loop-type antenna capable of receiving a wide frequency band of the electromagnetic spectrum, RM denotes an antenna biasing resistor, PI denotes a polarity inverter, OR denotes an OR gate circuit, CO denotes a comparator, ES denotes a terminal of the comparator CO to which a reference voltage is applied, TM denotes a timer, e.g., a monostable multivibrator, FF denotes a flip-flop circuit, RS denotes a self-returning manual reset switch, DR denotes a drive circuit, and LED denotes a light-emitting diode. These elements form a discharge detection circuit 2, which is separate from the sensing section 1.

In the apparatus shown in Fig. 1, when the flip-flop circuit FF is reset once with the reset switch RS to turn on and the first electrode E1 is placed within the electrostatic field to be measured, an electric charge of a magnitude related to the intensity of the electrostatic field to be measured is built up by electrostatic induction over the first electrode E1. It should be noted that after resetting the flip-flop circuit FF, the potential of a reset terminal R thereof is zero. When the magnitude or the electric charge exceeds a certain quantity derived from Paschen's law, a gaseous discharge is generated across the discharge gap G. When the gaseous discharge is generated, an electric voltage of a polarity determined by the direction of the discharge current is induced in the antenna A of the discharge detection circuit 2. The voltage induced in the antenna A is applied to the comparator CO either via the polarity inverter PI or OR gate circuit OR or via the OR gate circuit OR alone depending on the polarity of the induced voltage.

If the voltage applied to the comparator CO is higher than the reference voltage Ref applied via the terminal ES, the output voltage of the comparator CO goes high so that the flip-flop circuit FF is set via the timer TM. The set voltage from the flip-flop circuit FF is, in turn, applied to the drive circuit DR so that the light emitting diode LED emits light to indicate that the gaseous discharge has been generated across the gap G. Consequently, if the length of the gap G is known, the point within the electrostatic field at which the correspond break-down voltage obtains can be located. It should be noted that the distance between the electrodes E1 and E2 and antenna A only affects measurement sensitivity but does not affect potential measurement values. It should also be noted that since the reference voltage Ref applied to the comparator CO is provided so as to prevent the light-emitting diode LED from lighting erroneously due to noise, the magnitude of the reference voltage may be determined to be any arbitrary value.

In this way, if various insulating support structures wherein the lengths of the gap G differ from each other are prepared, the electric potential at any desired point of measurement can be measured. In addition, if the insulating support is so designed that the length of the gap G can be continuously adjusted, the electric potential at arbitrary measurement points can be measured from the instantaneous length of the gap G when the gaseous discharge occurs.

In the embodiment shown Fig. 1, the light-emitting diode LED serves to indicate that the gaseous discharge has been generated. In place of the light-emitting diode, other indicating means such as a buzzer BU shown in phantom lines of Fig. 1 may be used. In addition, any suitably sensitive circuit may be used in place of the discharge detection circuit 2 shown in Fig. 1.

Materials used for the first and second electrodes E1 and E2 and insulating support SI, their shapes, and the manner in which the first and second electrodes E1 and E2 are supported on the insulating support SI need not be limited as long as the electrodes E1 and E2 can be charged (electrified) by electrostatic induction so as to generate the gaseous discharge across the gap thereof. It should be noted that if the discharge area of the above-described first electrode E1 is smaller than the opposing second electrode E2 within a range of proportion at which the corona discharge will not occur across the gap G, the electric potential can be measured with even greater resolution.

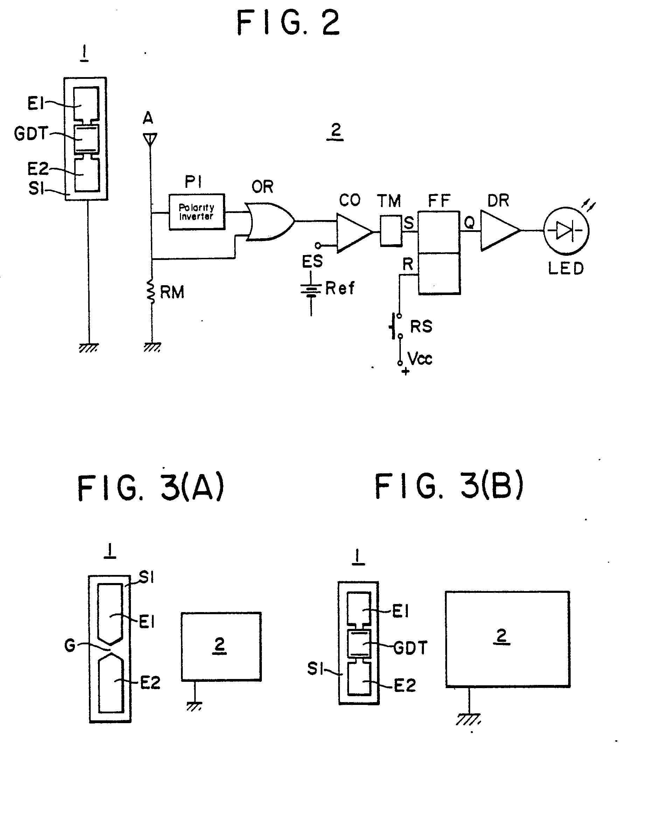

Fig. 2 shows second preferred embodiment according to the present invention.

As appreciated from Fig. 2, the construction of the discharge detection circuit 2 is the same as in the first embodiment shown in Fig. 1. However, since the electric potential sensor means 1 is different from that shown in Fig. 1, the electric potential sensor means 1 of the second preferred embodiment will be described hereinafter.

As shown in Fig. 2, the electric potential sensor means 1 in this embodiment includes a gas-filled discharge tube GDT, one of discharge electrodes thereof being connected to the first electrode E1 and the other discharge electrode being connected to the second electrode E2. The gas-filled discharge tube GDT is fixed to the insulating support SI together with the first and second electrodes E1 and E2 by means of, e.g., an appropriate adhesive.

In Fig. 2, when the insulating support SI, in which the first and second electrodes E1 and E2 and gas-filled discharge tube GDT are incorporated, is moved to an arbitrary point of either a direct current electric field or alternating-current electric field to be measured after the flip-flop circuit FF is reset by means of the reset switch RS, an electric charge appears on the first electrode E1 due to electrostatic induction, the magnitude of which is related to the electric potential to be measured. If the electric charge exceeds a predetermined value, the gas-filled discharge tube GDT discharges and an electric voltage is induced in the antenna A the polarity of which is determined by the direction of the discharge current. The induced voltage is applied to the OR gate circuit OR either directly or via the polarity inverting circuit PI depending on the polarity of the induced voltage, i.e., of the discharge current. The comparator CO compares the output voltage of the OR gate circuit OR with the reference voltage applied at the terminal ES. When the output voltage of the OR gate circuit OR exceeds the reference voltage in the comparator CO, the comparator CO outputs a high-level voltage signal to the timer TM which receives the high-level voltage signal and outputs a high-level voltage signal for a predetermined interval of time to set the flip-flop circuit FF. Therefore, the output of the flip-flop circuit FF actuates the drive circuit DR to illuminate the light emitting diode LED in the same manner as described in the first preferred embodiment.

It should be noted that since the predetermined value of the magnitude of electric charge described above, i.e., break-down voltage of the gas-filled discharge tube GDT is dependent on the shapes of the discharge electrodes, the discharge gap length, the kind of gas filling the discharge tube GDT and the pressure thereof, the break-down voltage of the gas-filled discharge tube GDT is known, and so when the illumination of the light-emitting diode LED signals discharge of the gas-filled discharge tube GDT, the electric field at the point of measurement is known to be at the known break-down voltage, at least.

In this embodiment, if a number of the sensors 1 shown in Fig. 2 of differing break-down discharge voltages, are prepared, the electric potential at any point of measurement in the electric field can be measured. In this case, any or all of the parameters determining the breakdown voltage, i.e., the shape of the discharge electrodes, the discharge gap length, the kind gas filling the gas-filled discharge tube GDT, and the pressure in the gas-filled discharge tube GDT, etc. may differ from one another. Alternatively, it is also possible to use a single sensor means of the type wherein gas-filled discharge tubes GDT differing break-down voltages can removably be interposed between the common first and second electrodes E1 and E2.

Furthermore, although Fig. 2 shows the case wherein the second electrode E2 is grounded, it is also possible to ground the first electrode E1 in place of the second electrode E2. In addition, if both first and second electrodes float with respect to ground as shown in Figs. 3(A) and 3(B), the apparatus according to the present invention can measure the potential difference between any two points in the electric field.

As described in the first embodiment with reference to Fig. 1, the materials, shapes, and manner of support of the first and second electrodes E1 and E2 on the insulating support SI may be selected arbitrarily as long as the first and second electrodes E1 and E2 can be charged by electrostatic induction so as to generate a discharge across the discharge gap of the gas-filled discharge tube GDT. The size, i.e., the cross-section of discharge of the discharge electrodes of the gas-filled discharge tube GDT may be reduced to within a range in which corona discharge will not occur. In this case, the electric potential can be measured with high resolution.

Since, in the second preferred embodiment, the small gas discharge tube is interposed between the first and second electrodes, it is possible to obtain a precise measurement of a lower electric potential than in the case when a gaseous discharge is generated through the atmosphere between the charged electrodes as shown in Fig. 1.

As described above, the apparatus for measuring the electric potential of an electrostatic field according to the present invention constructed as shown in the drawings can make accurate quantitative measurements of spatial electric potential and the electric potential of charged bodies.

## Claims

1. Apparatus for measuring electric potential using a discharge gap, the apparatus comprising:
first and second electrodes (E1, E2) opposing each other with a gaseous discharge gap (G) therebetween; and
means (2) for detecting and indicating the occurrence of a discharge across the discharge gap (G); characterized in that:
the first and second electrodes (E1, E2) constitute a sensor unit (1), the means for detecting the occurrence of a discharge across the discharge gap (G) comprises circuitry (2) which has no physical connection to the sensor unit (1), and in that the sensor unit (1) is positionable at any desired location within an electrostatic field to cause the electrodes (E1, E2) to be charged by electrostatic induction according to the value of the potential of the electrostatic field at that location so that the detection of a discharge between the electrodes (E1, E2) by the circuitry (2) is indicative of the electric potential at that location.

2. Apparatus as claimed in claim 1, wherein one of the electrodes (E1, E2) is electrically floating and the other is electrically grounded.

3. Apparatus as claimed in claim 1 or claim 2, wherein a plurality of sensor units (1) of mutually different inter-electrode gaps (G) are provided.

4. Apparatus as claimed in claim 1, wherein the inter-electrode gap (G) of the sensor unit (1) is continuously adjustable.

5. Apparatus as claimed in any preceding claim, wherein the circuitry (2) comprises an antenna (A) for receiving electromagnetic radiation generated on occurrence of a discharge between the electrodes (E1, E2) of the sensor unit (1).

6. Apparatus as claimed in any preceding claim, wherein the discharge area of either or both of the electrodes (E1, E2) of the or each sensor unit (1) is in a size range such that corona discharge will not occur across the inter-electrode gap (G).

7. Apparatus as claimed in any preceding claim, wherein the circuitry (2) comprises:

a discharge current receiving section (A, RM) for receiving electromagnetic radiation, generated when a discharge occurs across the inter-electrode gap (G), and generating a voltage with a polarity corresponding to that of the discharge current across the inter-electrode gap (G);

a comparator section (PI, OR, CO) for comparing the voltage generated by the discharge current receiving section (A, RM) with a reference voltage (Ref) and outputting a voltage signal when the voltage generated at the discharge current receiving section (A, RM) excees the reference voltage (Ref); and

an indicating section (TM, FF, RS, DR, LED) for indicating, when an output voltage is received from the comparator section (PI, OR, CO), that a discharge across the gap has occurred.

8. Apparatus as claimed in claim 7, wherein the discharge current receiving section (A, RM) includes a telescopic antenna (A).

9. Apparatus as claimed in claim 7, wherein the discharge current receiving section (A, RM) includes a loop antenna (A).

10. Apparatus as claimed in any one of claims 7, 8 and 9 wherein the indicating section (TM, FF, RS, DR, LED) includes a light emitting diode (LED).

11. Apparatus as claimed in any one of claims 7, 8 and 9 wherein the indicating section (TM, FF, RS, DR, LED) includes a buzzer (BU).

12. Apparatus as claimed in claim 1, wherein a gas-filled discharge tube (GDT) is interposed between the electrodes (E1, E2) of the sensor unit (1).

13. Apparatus as claimed in claim 12, wherein the sensor unit (1) comprises a structural unit in which any one of a plurality of gas-filled discharge tubes (GDT) with mutually different predetermined break-down voltages can be freely inserted and removed from between the electrodes (E1, E2).

14. Apparatus as claimed in claim 12, wherein a plurality of sensor units (1) are provided of which the gas-filled discharge tubes (GDT) have mutually different predetermined break-down voltages.

15. A method of measuring electric potential comprising:

using the detection, by circuitry (2), of a discharge across a gaseous discharge gap (G) between electrodes (E1, E2) as an indication of the value of the electric potential between the electrodes, characterized by:

positioning at a desired location within an electrostatic field a sensor unit (1) comprising first and second electrodes (E1, E2) opposing each other with the gaseous discharge gap (G) therebetween, thereby causing the electrodes (E1, E2) to be charged by electrostatic induction according to the value of the potential of the electrostatic field at that location, and

detecting the occurrence of a discharge across the discharge gap (G) by means of circuitry (2) which has no physical connection to the sensor unit (1).

16. A method as claimed in claim 15, wherein a plurality of sensor units (1) of mutually different inter-electrode gaps (G) are provided for use in the method.

17. A method as claimed in claim 15, wherein the length of the inter-electrode gap (G) is continuously adjusted and the electric potential is measured by the instantaneous length of the inter-electrode gap (G) when a discharge occurs.

## Patentansprüche

1. Vorrichtung zum Messen des elektrischen Potentials unter Benutzung eines Entladungsspaltes, mit:

ersten und zweiten Elektroden (E1, E2), die einander mit einem dazwischenliegenden gashaltigen Entladungsspalt (G) gegenüberliegen; und

mit Mitteln (2) zum Erfassen und Anzeigen des Auftretens einer Entladung über den Entladespalt (G); dadurch gekennzeichnet, daß:

die ersten und zweiten Elektroden (E1, E2) eine fühlereinheit (1) bilden, das Mittel zum Erfassen des Auftretens einer Entladung über den Entladungsspalt (G) eine Schaltung (2) umfaßt, die keine körperliche Verbindung mit der Fühlereinheit (1) besitzt, und

die Fühlereinheit (1) an jede gewünschte Stelle innerhalb eines elektrostatischen Feldes setzbar ist, um die Elektroden (E1, E2) durch elektrostatische Induktion entsprechend dem Wert des Potentials des elektrostatischen Feldes an der Stelle aufladen zu lassen, so daß die Erfassung einer Entladung zwischen den Elektroden (E1, E2) durch die Schaltung (2) für das elektrische Potential an der Stelle bezeichnend ist.

2. Vorrichtung nach Anspruch 1, bei der eine der Elektroden (E1, E2) elektrisch frei und die andere elektrisch geerdet ist.

3. Vorrichtung nach Anspruch 1 oder 2, bei der eine Vielzahl von Fühlereinheiten (1) mit jeweils unterschiedlichen Zwischen-Elektrodenspalten (G) vorgesehen ist.

4. Vorrichtung nach Anspruch 1, bei der der Zwischen-Elektrodenspalt (G) der Fühlereinheit (1) kontinuierlich einstellbar ist.

5. Vorrichtung nach einem der vorangehenden Ansprüche, bei der die Schaltung (2) eine Antenne (A) zum Empfang beim Auftreten einer Entladung zwischen den Elektroden (E1, E2) der Fühlereinheit (1) erzeugter elektromagnetischer Strahlung umfaßt.

6. Vorrichtung nach einem der vorangehenden Ansprüche, bei der die Entladungsfläche einer Elektrode oder beider Elektroden (E1, E2) der oder jeder Fühlereinheit (1) in einem solchen Größenbereich liegt, daß keine Coronaentladung über dem Zwischen-Elektrodenspalt (G) auftritt.

7. Vorrichtung nach einem der vorangehenden Ansprüche, bei der die Schaltung (2) umfaßt:

einen Entladungsstrom-Empfangsabschnitt (A, RM) zum Empfang elektromagnetischer, beim Auftreten einer Entladung über dem Zwischen-Elektrodenspalt (G) erzeugten Strahlung und zum Erzeugen einer Spannung mit einer Polarität, die der des Entladungsstromes über dem Zwischen-Elektrodenspalt (G) entspricht;

einen Komparatorabschnitt (PI, OR, CO) zum Vergleichen der durch den Enladungsstrom-Empfangsabschnitt (A, RM) erzeugten Spannung mit einer Referenzspannung (Ref) und zum Ausgeben eines Spannungssignales, wenn die bei dem Entladungsstrom-Empfangsabschnitt (A, RM) erzeugte Spannung die Referenzspannung (Ref) übertrifft; und

einen Anzeigeabschnitt (TM, FF, RS, DR, LED) zum Anzeigen, wenn eine Ausgangsspannung von dem Komparatorabschnitt (PI, OR, CO) empfangen wird, daß eine Entladung über dem Spalt aufgetreten ist.

8. Vorrichtung nach Anspruch 7, bei der der Entladungsstrom-Empfangsabschnitt (A, RM) eine Teleskop-Antenne (A) enthält.

9. Vorrichtung nach Anspruch 7, bei der der Entladungsstrom-Empfangsabschnitt (A, RM) eine Schleifen-Antenne (A) enthält.

10. Vorrichtung nach einem der Ansprüche 7, 8 oder 9, bei der der Anzeigeabschnitt (TM, FF, RS, DR, LED) eine Leuchtdiode (LED) enthält.

11. Vorrichtung nach einem der Ansprüche 7, 8 oder 9, bei der der Anzeigeabschnitt (TM, FF, RS, DR, BU) einen Summer (BU) enthält.

12. Vorrichtung nach Anspruch 1, bei der eine gasgefüllte Entladungsröhre (GDT) zwischen die Elektroden (E1, E2) der Fühlereinheit (1) eingesetzt ist.

13. Vorrichtung nach Anspruch 12, bei der die Fühlereinheit (1) eine Baueinheit umfaßt, in der irgendeine aus einer Vielzahl gasgefüllter Entladungsröhren (GDT) mit jeweils unterschiedlichen vorbestimmten Durchbruchspannungen frei zwischen die Elektroden (E1, E2) eingesetzt und von dort entfernt werden kann.

14. Vorrichtung nach Anspruch 12, bei der eine Vielzahl von Fühlereinheiten (1) vorgesehen ist, deren gasgefüllte Entladungsröhren (GDT) jeweils unterschiedliche vorbestimmte Durchbruchspannungen besitzen.

15. Verfahren zum Messen elektrischen Potentials, mit:

Benutzen der Erfassung einer Entladung über einem gashaltigen Entladungsspalt (G) zwischen Elektroden (E1, E2) durch eine Schaltung (2) als eine Anzeige für den Wert des elektrischen Potentials zwischen den Elektroden, gekennzeichnet durch:

Einsetzen einer Fühlereinheit (1), die erste und zweite Elektroden (E1, E2) einander gegenüberliegend mit dazwischen befindlichem gashaltigen Entladungsspalt (G) umfaßt, an eine gewünschte Stelle innerhalb eines elektrostatischen Feldes, um dadurch die Elektroden (E1, E2) durch elektrostatische Induktion entsprechend dem Wert des Potentials des elektrostatischen Feldes an der Stelle aufladen zu lassen, und

Erfassen des Auftretens einer Entladung über dem Entladungsspalt (G) mittels der Schaltung (2), die keine körperliche Verbindung mit der Fühlereinheit (1) besitzt.

16. Verfahren nach Anspruch 15, bei dem eine Vielzahl von Fühlereinheiten (1) mit jeweils unterschiedlichen Zwischen-Elektrodenspalten (G) zur Verwendung in dem Verfahren vorgesehen sind.

17. Verfahren nach Anspruch 15, bei dem die Länge des Zwischen Elektrodenspaltes (G) kontinuierlich eingestellt wird, und das elektrische Potential durch die augenblickliche Länge des Zwischen-Elektrodenspaltes (G) beim Auftreten einer Entladung gemessen wird.

## Revendications

1. Appareil de mesure d'un potentiel électrique en utilisant un intervalle de décharge, l'appareil comportant:

une première et une seconde électrodes (E1, E2) en face l'une de l'autre avec un intervalle de décharge dans un gaz (G) entre elles; et

un dispositif (2) de détection et d'indication de l'apparition d'une décharge dans l'intervalle de décharge (G); caractérisé en ce que:

la première et la seconde électrodes (E1, E2) constituent une unité de capteur (1), le dispositif de détection de l'apparition d'une décharge dans l'intervalle de décharge (G) comportant un circuit (2) qui n'a aucune connexion physique avec l'unité de capteur (1) et en ce que l'unité de capteur (1) peut être positionnée en tout endroit voulu dans un champ électrostatique pour que les électrodes (E1, E2) soient chargées par induction électrostatique en fonction de la valeur du potentiel du champ électrostatique à cet endroit de manière que la détection d'une décharge entre les électrodes (E1, E2) par le circuit (2) indique le potentiel électrique à cet endroit.

2. Appareil selon la revendication 1, dans lequel l'une des électrodes (E1, E2) est flottante électriquement tandis que l'autre est électriquement à la masse.

3. Appareil selon la revendication 1 ou la revendication 2, dans lequel plusieurs unités de capteurs (1) avec des intervalles (G) entre électrodes mutuellement différents sont prévues.

4. Appareil selon la revendication 1, dans lequel l'intervalle (G) entre électrodes de l'unité de capteur (1) est réglable de façon continue.

5. Appareil selon l'une quelconque des revendications précédentes, dans lequel le circuit (2) comporte une antenne (A) destinée à recevoir un rayonnement électromagnétique produit à l'apparition d'une décharge entre les électrodes (E1, E2) de l'unité de capteur (1).

6. Appareil selon l'une quelconque des revendications précédentes, dans lequel la région de décharge de l'une ou des deux électrodes (E1, E2) de l'unité ou de chaque unité de capteur (1) se situe dans une plage de dimensions telles qu'aucune décharge par effet couronne ne se produit dans l'intervalle (G) entre électrodes.

7. Appareil selon l'une quelconque des revendications précédentes, dans lequel le circuit (2) comporte:

une section de réception de courant de décharge (A, RM) destinée à recevoir un rayonnement électromagnétique développé lorsqu'une décharge se produit dans l'intervalle (G) entre électrodes, et produisant une tension avec une polarité qui correspond à celle du courant de décharge dans l'intervalle (G) entre électrodes;

une section de comparateur (PI, OR, CO) destinée à comparer la tension développée par la section de réception de courant de décharge (A, RM) avec une tension de référence (Ref) et émettant un signal de tension lorsque la tension développée à la section de réception de courant de décharge (A, RM) dépasse la tension de référence (Ref); et une section d'indication (TM, FF, RS, DR, LED) pour indiquer, lorsqu'une tension de sortie est reçue de la section de comparateur (PI, OR, CO) qu'une décharge s'est produite dans l'intervalle.

8. Appareil selon la revendication 7, dans lequel la section de réception de courant de décharge (A, RM) comporte une antenne télescopique (A).

9. Appareil selon la revendication 7, dans lequel la section de réception de courant de décharge (A, RM) comporte une antenne à cadre (A).

10. Appareil selon l'une quelconque des revendications 7, 8 et 9 dans lequel la section d'indication (TM, FF, RS, DR, LED) comporte une diode électroluminescente (LED).

11. Appareil selon l'une quelconque des revendications 7, 8, et 9 dans lequel la section d'indication (DM, FF, RS, DR, BU) comporte un ronfleur (BU).

12. Appareil selon la revendication 1, dans lequel un tube à décharge dans un gaz (GDT) est intercalé entre les électrodes (E1, E2) de l'unité de capteur (1).

13. Appareil selon la revendication 12, dans lequel l'unité de capteur (1) consiste en une unité de structure dans laquelle l'un quelconque de plusieurs tubes à décharge dans un gaz (GDT) avec des tensions d'amorçage prédéterminées et mutuellement différentes peuvent être intercalés librement et enlevés d'entre les électrodes (E1, E2).

14. Appareil selon la revendication 12, dans lequel plusieurs unités de capteurs (1) sont prévues, dont les tubes à décharge dans un gaz (GDT) ont des tensions d'amorçage prédéterminées et mutuellement différentes.

15. Procédé de mesure d'un potentiel électrique consistant:

à utiliser la détection, par un circuit (2) d'une décharge dans un intervalle de décharge dans un gaz (G) entre des électrodes (E1, E2) comme une indication de la valeur du potentiel électrique entre les électrodes, caractérisé en ce qu'il consiste:

à positionner à un endroit voulu dans un champ électrostatique, une unité de capteur (1) comprenant une première et une seconde électrodes (E1, E2) se faisant face avec l'intervalle de décharge dans un gaz (G) entre elles de manière que les électrodes (E1, E2) soient chargées par induction électrostatique en fonction de la valeur du potentiel du champ électrostatique en cet endroit, et

à détecter l'apparition d'une décharge dans l'intevalle de décharge (G) au moyen d'un circuit (2) qui n'a aucune connexion physique avec l'unité de capteur (1).

16. Procédé selon la revendication 15, dans lequel plusieurs unités de capteurs (1) ayant des intervalles entre électrodes (G) mutuellement différents sont prévus pour la mise en oeuvre du procédé.

17. Procédé selon la revendication 15, dans lequel la longueur de l'intervalle entre électrodes (G) est réglée de façon continue et le potentiel électrique est mesuré par la longueur instantanée de l'intervalle entre électrodes (G) lorsqu'une décharge se produit.

# FIG. 1

# FIG. 2

# FIG. 3(A)

# FIG. 3(B)